# EUROPEAN PATENT APPLICATION

(11) **EP 4 811 664 A1**
(43) Date of publication of application: **23.09.2026**
(21) Application number: 25164384.7
(22) Date of filing: 18.03.2025
(51) Int. Cl.: H03K 19/096, G06F 9/448

(54) **ASYNCHRONOUS DIGITAL CONTROL CIRCUIT, RFID DEVICE AND METHOD THEREFOR**

(71) Applicant: NXP B.V., 5656 AG Eindhoven (NL)
(72) Inventor: Weidinger, Christian, 5656 AG Eindhoven, (NL)
(74) Representative: Krott, Michel

(57) **Abstract**

An asynchronous digital control circuit (200) includes a FSM state vector circuit (210) and a plurality of sequential logic circuits (300). A number of sequential logic circuits comprise: a first input (310) arranged to receive a sequential logic circuit analog event enable signal from the state vector circuit; a register (360) captures an occurrence of an analog event; a logic gate (370) gates an output of the register with a previous digital control circuit action (372) to provide mutually exclusive actions. A second analog input receives a respective captured analog event signal (320); and an analog event condition circuit (350) combines a plurality of analog input signals to form an analog event signal. An output is at least one action to control an analog circuit in response to the respective captured analog event signal and the sequential logic circuit analog event enable signal.

## Description

### Technical Field

The technical field relates generally to a radio frequency identifier (RFID) device with a digital control circuit and a method for asynchronous adjustment of an output analog control signal. The technical field is applicable to, but not limited to, a digital control circuit to asynchronously adjust an output analog control signal, based on captured analog events, for example to control an analog circuit without using a clock signal or an oscillator of an RFID device.

### Background

Radio-frequency identification (RFID) has an enormous variety of uses, ranging from public transportation to animal identification to product tracking. In industrial environments, RFID tags are used to track parts or assets, which is useful for automation and/or logistical purposes.

It is known that optimisation of an RFID device's/tag's performance requires a detection of an actual radio frequency (RF) power level, which is used to adjust a tuneable input impedance. Such an approach to tune the RFID device's/tag's input impedance is known as a self-adjust or a self-tuning circuit. Known implementations of such a self-adjust circuits use standard synchronous digital logic, i.e., based on a reliable clock signal, which requires an oscillator operating at a specific frequency. This adds cost and complexity to an RFID device/tag. Alternatively, it is known that some self-adjust techniques are based on analog delay elements. A synchronous digital circuit typically uses flip-flops, as this circuit element is better supported by design tools. In a synchronous digital circuit, the clock signal drives the activity, e.g., where analog inputs are sampled, the state of the digital circuit is accordingly changed and the outputs are updated. In semiconductor circuits, and especially semiconductor circuits for RFID devices where a clocked system is employed, it is often known that digital latches/flip-flops switch at the same time. The input signals are synchronized by two flip-flops each to avoid metastability propagating into the digital circuit, where the input signals directly influence the next phase (sometimes referred to as a self-adjust phase of a finite state machine (FSM)) where the next values of the outputs/state flags are taken over at the next clock edge.

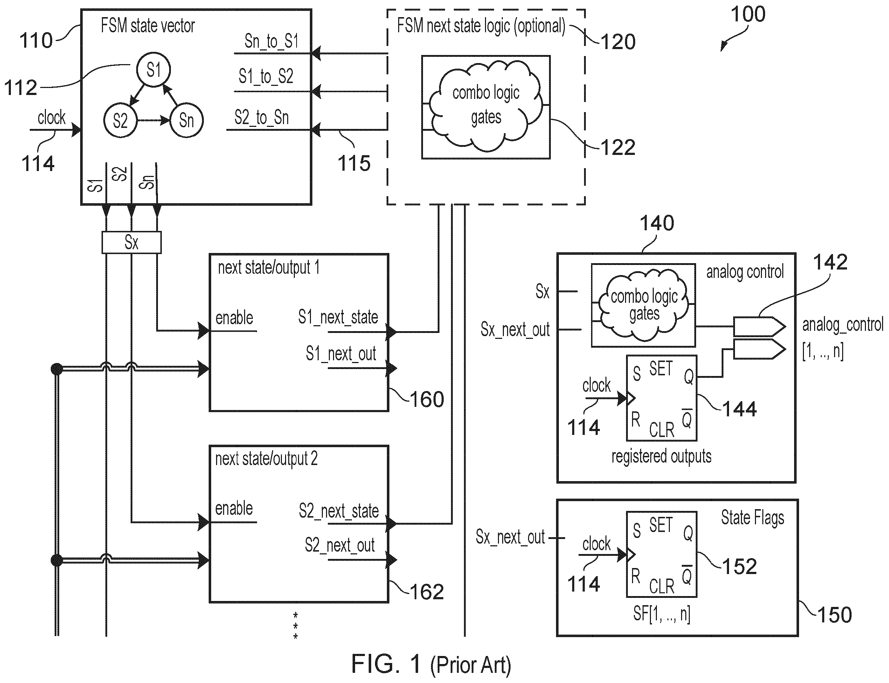

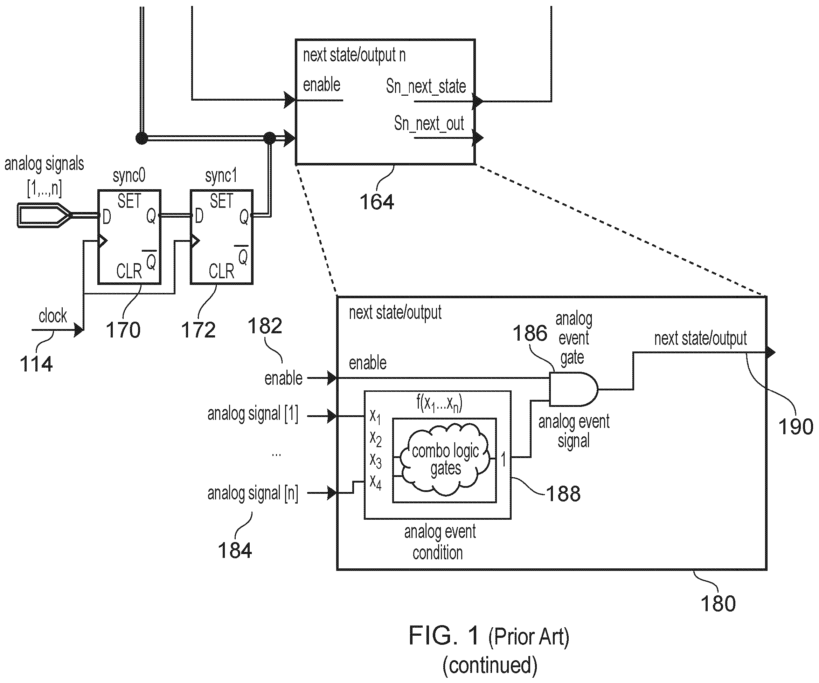

Referring now to FIG. 1, a known synchronous implementation 100 (i.e., that uses a clock signal 114) is illustrated for tuning a radio frequency (RF) input impedance matching circuit. The synchronous implementation 100 includes a FSM state vector circuit 110 that comprises multiple states 112 (e.g., states S1 ... Sn) where the FSM state vector circuit 110 receives a clock signal 114 and is informed of state changes 115 from a FSM next state logic circuit 120. The FSM next state logic circuit 120 includes multiple combinations of logic gates 122. FSM state vector circuit 110 includes respective outputs, arranged as 'enable' signals, provided to multiple next state (e.g., states S1 ... Sn) digital circuits 160, 162, 164. FSM next state logic 120 may just pass through the actions to go to the next state inputs of the state vector, i.e. S1_action → S1_to_S2; S2_action → S2_to_Sn; Sn_action → Sn_to_S1.

Analog event signals are input into a D-type flip flop 170 of the synchronous implementation 100, with state changes triggered by a clock signal 114, and where a first D-type flip flop 170 'Q' output is input into a D'D' input of a second D-type flip flop 172, with the output 'Q' of the second D-type flip flop 172 input into each of the multiple next state digital circuits 160, 162, 164 to provide a synchronised analog event signal thereto. An output from each of the multiple next state digital circuits 160, 162, 164 is input to FSM next state logic circuit 120. It is known that an FSM is defined by a list of its states, its initial state, and the inputs that trigger each transition. An FSM can be in exactly one of a finite number of states at any given time. The FSM can change from one state to another in response to some inputs; the change from one state to another is termed a 'transition'. Depending on the application, phases or steps in a sequence can be mapped to the states of an FSM. The implementation 100 also includes an analog control digital circuit 140 having state inputs and a clock signal 114 input to a latch, in a form of a S-R flip-flop 144 and multiple combinations of logic gates 122 with analog control outputs 142. The implementation 100 also includes state flags 150 having next state inputs and a clock signal 114 input to a latch, in a form of a S-R flip-flop 152. Although all information about a current status of an FSM could be stored in a FSM state vector, a known practice is to store specific information in dedicated registers, often referred to as 'state flags'. Examples of state flags include loop counters, operating modes or end conditions.

Each of the multiple next state (e.g., states S1 ... Sn) digital circuits 160, 162, 164 includes an enable input signal 182 and multiple analog signals (1 ...n) 184 that are input into an analog event condition logic circuit 188. The analog event condition logic circuit 188 and the enable input signal 182 are input to a logic 'AND' gate 186, which provides the next state output 190. In this manner, the analog input signals are logically combined to a condition for the next state respectively a change of the outputs. This analog event condition is gated by the enable input signal 182 of the corresponding state (e.g., states S1 ... Sn).

The inventor has recognized and appreciated that in providing a synchronous approach, for example to tuning the RFID input impedance, the use of an oscillator to provide a clock signal requires additional silicon area and consumes additional power. Furthermore, the inventor has recognized and appreciated that the performance of a control circuit to adjust components in such an RFID input impedance circuit is strongly dependent on process-voltage-temperature (PVT) changes.

US10929734 describes a mechanism that uses a second clock frequency, independent of the main system clock, in order to run an input impedance tuning algorithm of a radio frequency (RF) matching circuit. US11481595B2, describes a known tuning principle with a five-cap-step input impedance tuning algorithm. Accordingly, there is a need for an improved device and method to support timing adjust of analog signals, such as a tuneable input impedance of an RFID device.

### Summary

Examples described herein provide a digital control circuit and a RFID device and a method for asynchronous adjustment of an output analog control signal in response to captured analog events (e.g., for tuning an analog circuit, such as a radio frequency (RF) input impedance matching circuit, in an asynchronous manner, that does not use a clock signal), as described in the accompanying claims. Specific examples are set forth in the dependent claims. These and other aspects will be apparent from and elucidated with reference to the examples described hereinafter.

### Brief description of the drawings

Further details, aspects and examples will be described, by way of example only, with reference to the drawings. In the drawings, like reference numbers are used to identify like or functionally similar elements. Elements in the figures are illustrated for simplicity and clarity and have not necessarily been drawn to scale.
FIG. 1 illustrates a known Finite State Machine (FSM) arranged to synchronously (i.e., that uses a clock signal) control an analog circuit such as for tuning a radio frequency (RF) input impedance matching circuit.
FIG. 2 illustrates a block diagram of an asynchronous implementation (i.e., one that does not use a clock signal) for controlling an analog circuit, e.g., for tuning a RF input impedance matching circuit, adapted in accordance with some examples.
FIG. 3 illustrates one example of a sequential logic circuit, for example in a form of an action flip-flop circuit, in order to capture analog events and control an analog circuit, e.g., tune an RF input impedance matching circuit in an asynchronous manner without using a clock signal or an oscillator, according to examples.
FIG. 4 illustrates a number of example embodiments of sequential logic circuits, according to examples.
FIG. 5 illustrates a block diagram of a RFID device comprising a digitally controlled analog RF impedance tuning circuit, adapted in accordance with some examples.
FIG. 6 illustrates one example of an asynchronous timing diagram for controlling an analog circuit, e.g., for tuning a RF input impedance matching circuit, according to examples.
FIG. 7 illustrates an overview example of a flowchart for a method for an asynchronous digital control circuit comprising a plurality of sequential logic circuits, for example for adjusting a tunable input impedance of a RFID device, according to some examples.

### Detailed description

The inventor has recognized and appreciated that, particularly for radio frequency identifier (RFID) device chips, dynamically optimizing the RF input impedance is important to achieve good performance. Furthermore, the existing approach to use a synchronous (self-adjusting) approach to optimizing the RF input impedance adds complexity and cost. Therefore, in order to overcome the identified problem, examples herein-described propose an asynchronous approach that respond to captured analog events, thereby removing any need for a clock/oscillator signal. In some examples, the asynchronous approach employs a digital circuit configured with a number of registers, e.g., termed action flip flops, configured to capture analog events and control an analog circuit in an asynchronous and self-timed way, i.e., without using a clock signal. Furthermore, the examples herein-described propose an asynchronous approach that provides a direct response to analog events, e.g., without a need to wait for a clock, ensures a more accurate performance as there is less spread over process-voltage-temperature (PVT) changes, which can typically not be compensated by component trimming, as available power before tuning and time do not permit to read the trimming data from a memory.

It is known that RFID circuits have very restricted budgets for power, silicon (chip) area and supply voltage, not least as they tend to be (or include) passive circuits where there is no battery. Furthermore, in a context of an input impedance self-adjust application, the constraints are even more strict as such circuits need to be able work below the power level of the main circuitry of the RFID chip in order to tune the resonance circuit. The supply voltage therefore is close to the transistor threshold voltage leading to a large variation of the digital gate speed. Therefore, it is envisaged that the examples herein-described may provide a high tolerance to logic gate speed variations, which are characteristic for systems that have to work close to a threshold voltage, such as with a low-power RFID device.

Although examples are described herein with reference to an RFID device, it is envisaged that the concepts described are equally applicable to any low power device. Furthermore, although examples are described herein with reference to the analog control signal being used to tune an input impedance of an RFID device, it is envisaged that the concepts described are equally applicable to controlling any suitable analog circuit that may benefit from an asynchronous approach rather than a synchronous (clock-based) approach.

It is also known that in, say, RFID self-adjust / self-tuning circuits, the clock frequency typically has a large/variable spread of frequencies as the oscillator and bias currents cannot be trimmed due to the lack of a non-volatile memory in the RFID self-adjust / self-tuning circuits, which works reliably at these voltage levels. This makes the timing closure challenging in a synchronous system. However, in the example asynchronous approach, the analog events happen in a defined order, with one signal gating the next signal in a desired and known order. To achieve a defined order of events, the proposed circuit makes sure that one state or action has finished before starting the next one, i.e. each state or action has a preliminary signal that is assigned to the acting state or action signal once the previous state or action signal was de-asserted.

In some examples, in an asynchronous adjustment of an output analog control signal, the digital circuit may execute different phases, for example where the analog control signal performs a capacitance adjustment of an input capacitor in an impedance circuit and determines whether (or not) this input capacitor change improves, say, the RFID supply. These different phases may be stored in a phase FSM. A number of analog events, such as a result of a supply voltage comparison or a timeout, are captured by latches (e.g., flip-flops, which may be RS-latches or D-flip flops), which then drive the required event action as a response to this event throughout the complete circuit. Each possible event action, e.g., as a response to an observed supply improvement or to a timeout elapsed, has its own dedicated, respective action flip-flop. Thus, an action flip-flop is activated by a dedicated phase. It is set at the expected analog event, e.g., positive edge at a first comparator, and then drives the necessary action throughout the circuitry. In some examples, this may be the state flags of an algorithm that controls the input impedance capacitances or finally the transition to the next phase.

In a first aspect, an asynchronous digital control circuit is described that comprises a finite state machine, FSM, state vector circuit arranged to receive and hold operational state changes of the asynchronous digital control circuit. A plurality of sequential logic circuits is operably coupled to the FSM state vector circuit. A number of sequential logic circuits comprise: a first input arranged to receive a sequential logic circuit analog event enable signal from the FSM state vector circuit; a register arranged to capture an occurrence of an analog event; a logic gate coupled to an output of the register and arranged to gate the output of the register with a previous digital control circuit action to provide mutually exclusive actions; a second analog input arranged to receive a respective captured analog event signal; and an analog event condition circuit having a plurality of combined logic circuits operably coupled to the second analog input and arranged to combine a plurality of analog input signals to an analog event signal. An output is arranged to output at least one action to control an analog circuit in response to the respective captured analog event signal and the sequential logic circuit analog event enable signal.

In a second aspect, a radio frequency identifier, RFID, device is described that comprises an asynchronous digital control circuit according to the first aspect.

In a third aspect, a method for an asynchronous digital control circuit comprising a plurality of sequential logic circuits is described. The method comprises: receiving and holding operational state changes of the asynchronous digital control circuit at a finite state machine, FSM, state vector circuit; receiving a sequential logic circuit analog event enable signal from the FSM state vector circuit at a first input of a respective sequential logic circuit; and capturing an occurrence of an analog event at a register by the respective sequential logic circuit. The method further comprises gating an output of the register with a previous digital control circuit action to provide mutually exclusive actions at a logic gate of the respective sequential logic circuit; receiving a respective captured analog event signal at a second analog input of the respective sequential logic circuit; and combining a plurality of analog input signals and forming an analog event signal by an analog event condition circuit. The method further comprises outputting at least one action that controls an analog circuit in response to the respective captured analog event signal and the sequential logic circuit analog event enable signal.

As described herein, in a digital circuit, the term 'register' is intended to encompass all variations of sequential elements (i.e., a circuit element whose output depends on the present value of its input signals and on the sequence of past inputs), as would be understood by a skilled person, including but not limited to latches (often understood as being clock level sensitive sequential elements) and flip-flops (often understood as being clock edge sensitive sequential elements), such that registers, latches and flip-flops are to be understood as being used interchangeably within the description. For completeness, in examples herein described, latches are often used (due to their smaller IC area) but also flip-flops, if capturing 'edges' of signals may be used if required.

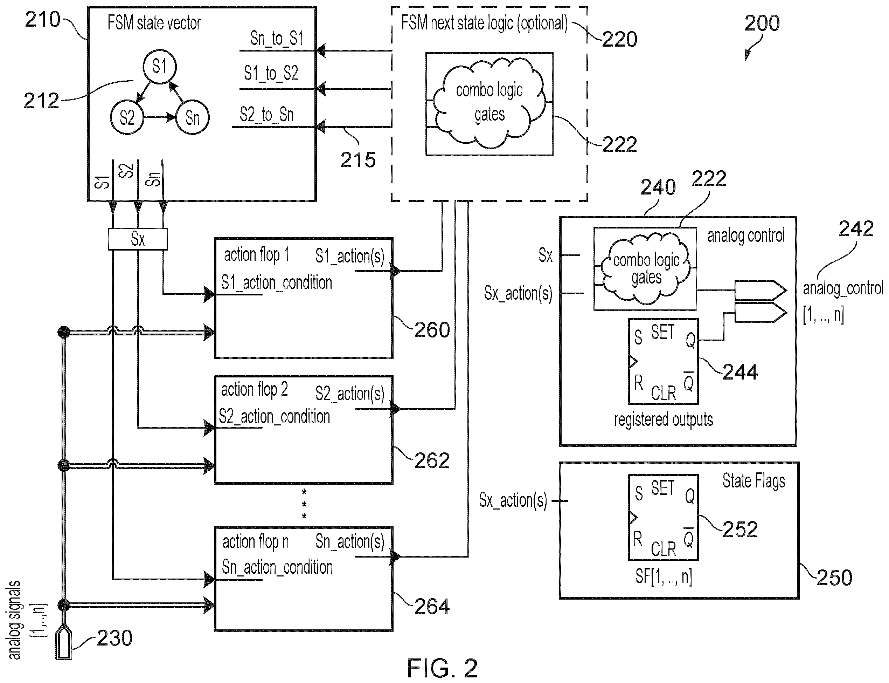

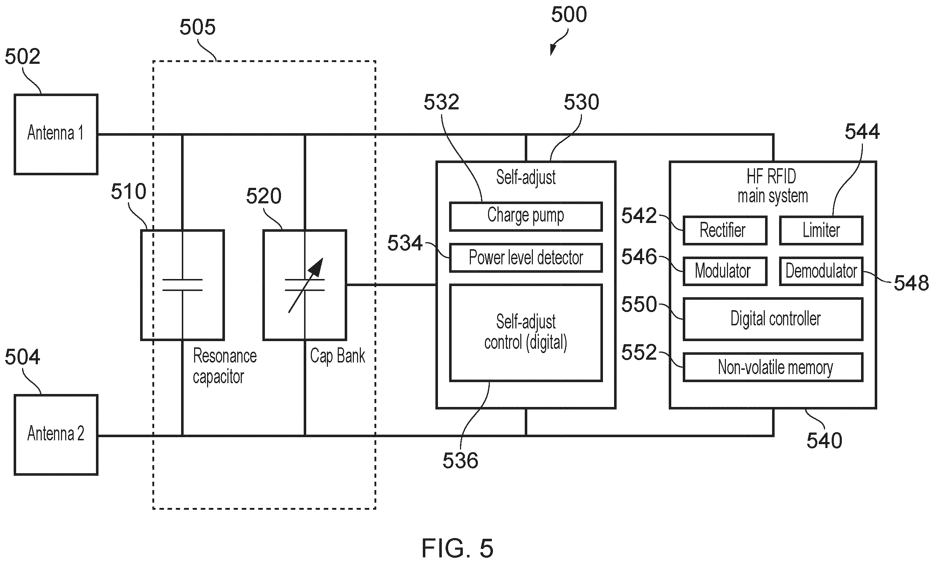

Referring now to FIG. 2, a block diagram of an asynchronous digital control circuit (which in this example is an asynchronous FSM system 200), adapted in accordance with some examples is illustrated (i.e., one that does not use a clock signal). In some examples, the asynchronous FSM system 200 may be used to control an analog circuit, e.g., for tuning a RF input impedance matching circuit (as described with reference to FIG. 5). The asynchronous FSM system 200 includes a FSM state vector circuit 210 that comprises multiple states (e.g., states S1 ... Sn) 212 that are informed of state changes 215 from a FSM next state logic circuit 220. The FSM next state logic circuit 220 includes multiple combinations of logic gates 222. In accordance with some examples, FSM state vector circuit 210 includes respective outputs, arranged as state action condition signals, provided to multiple sequential logic digital circuits 260, 262, 264 (e.g., one for each of the states S1 ... Sn).

In examples described herein, the FSM state vector (S1, S2, .., Sn) 210 indicates a step in a sequence, where all steps are mutually exclusive, as illustrated in example mapping table 1. Here, the phrase 'mutually exclusive' describes two or more events that cannot happen simultaneously.

**Example Mapping Table 1: FSM state vector:**

| | | |
|---|---|---|
| FSM state vector | tuning phases are mapped to the FSM state vector: | |
| | trying a cap and deciding is done in 3 phases | |
| | | • S1 = Reset: |
| | | reset the sample cap of the antenna envelope voltage |
| | | • S2 = Sample: |
| | | sample the current antenna envelope voltage • S3 = Cap/decide: |
| | | try the next tuning cap setting and decide to keep or revert the setting |

The FSM state vector (S1, S2, .., Sn) 210 controls an enabling of a sequential logic circuit, for example in a form of latches (e.g., action flip flops) 260, 262, 264, in order to control analog circuits. In each FSM state the latches (e.g., action flip flops) 260, 262, 264 are activated by (act_cond) signals, and triggered by analog event inputs that are combined by the analog event condition. These latches (e.g., action flip flops) 260, 262, 264 drive the necessary actions throughout the digital circuit, including analog control, set/reset of state flags, goto next state, etc. It is noted that all actions are mutually exclusive and that each action is gated by the action(s) of the previous phase. Furthermore, each latch (e.g., action flip flop) 260, 262, 264 is reset by the latch of the next phase, i.e. the next phase sequential logic circuit (latch 260, 262, 264).

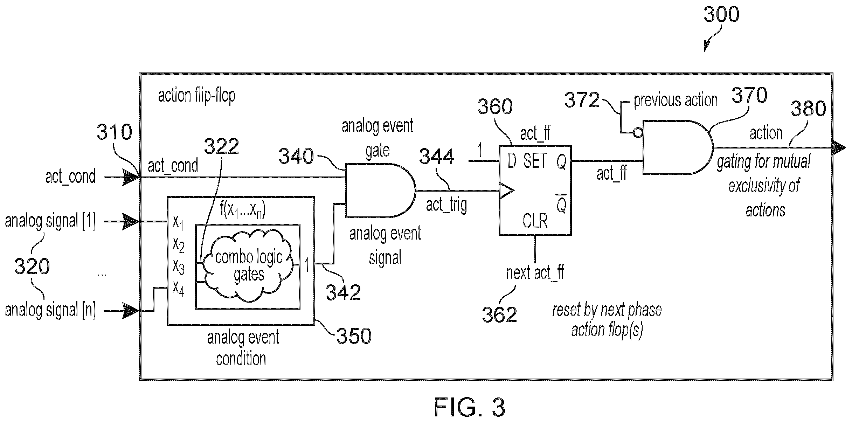

Analog signals 230 are also input into each of the multiple sequential logic digital circuits 260, 262, 264, referred to in this example as 'action flip flops 1..n', as described in FIG. 3. Thus, in such an implementation without a clock, the only events available to drive all the activity in a digital context (e.g., states and output any change/update) are the analog input signals, as illustrated in example mapping table 2. A state action output (S1_action(s) ... Sn_action(s)) from each of the multiple sequential logic digital circuits 260, 262, 264 is input to FSM next state logic circuit 220.

**Example Mapping Table 2: analog inputs / events:**

| | | |
|---|---|---|
| analog inputs / events | | • Signal indicating the increase of the antenna envelope voltage (= tuning in the right direction) |
| | | • signal indicating no change or decrease of the antenna envelope voltage |

The asynchronous FSM system 200 also includes an analog control digital circuit 240 having state inputs and state action inputs that are input to multiple combinations of logic gates 222 with analog control outputs 242. In this example, a latch, in a form of a S-R latch (e.g., a SR flip flop 244) is used to latch some of the analog control outputs 242. In some examples, the analog control outputs 242 are used to control the connected analog circuitry, for example an input capacitance bank by enabling or disabling components or switches to insert or remove capacitances from a RF impedance matching circuit, as illustrated in example mapping table 3. The outputs can be combinationally derived from the FSM state vector or actions or have their dedicated registers, which can be set/reset by the actions.

**Example Mapping Table 3: analog control outputs:**

| | | | |
|---|---|---|---|
| analog control outputs | | • input capacitor bank | |
| | | controls the input capacitance of the chip, 5 possibilities: 0 to 4 unity capacitances connected; split into two ways: | |
| | | | • capacitance direct combinatorial enables: |
| | | | used to try out a capacitance; directly controlled by S3 = Cap/decide |
| | | | • capacitance latches: |
| | | | once the decision on a cap is taken, the corresponding latch of that unity capacitance is asserted/de-asserted |
| | | • control of the antenna envelope detector and sampling circuit | |

The asynchronous FSM system 200 also includes state flags 250 having state actions (again) input to a latch, in a form of a S-R latch 252. State flags 250 are used to hold variables, which in some examples may be variables of an input impedance circuit tuning algorithm, as illustrated in example mapping table 4.

**Example Mapping Table 4: state flags:**

| | |
|---|---|
| state flags | • direction: |
| | indicates whether the control circuit is adding or removing input capacitance |
| | • tuning round: |
| | indicates whether this is the first or the second step in the current direction. |
| | 5 input capacitance steps allow 2 steps in one direction. |
| | • Finished: |
| | indicates that the self-adjust algorithm has reached its exit condition and has concluded on the input capacitance. |

Referring now to FIG. 3, one example of a sequential logic circuit 300 is illustrated, for example in a form of an action flip-flop circuit, in order to capture analog events and control an analog circuit. In some examples, the analog circuit to be controlled by a sequential logic circuit 300 may be an RFID input impedance circuit, where the analog control signals may be used to tune an RF input impedance matching circuit in an asynchronous manner. In this example, the sequential logic circuit 300 includes an action condition input, for example received from the FSM state vector circuit 210 in FIG. 2, and analog input signals (1 .. n) 320.

In this example, but not all envisaged implementations, the analog input signals (1 .. n) 320 are input to an analog event conditioning circuit 350 that includes a plurality of combined logic gates or circuits 322 that define/dictate what combination of analog input signals will trigger an action. The analog event conditioning circuit 350 is operably coupled to a second analog input and is arranged to combine a plurality of analog input signals to form an analog event signal. An analog event gate output 342 from the analog event conditioning circuit 350 is input to a logic gate, for example AND'ed in AND logic gate 340 herein referred to as an 'analog event gate', that is used to pass through or block the analog event depending on the action condition. Thus, in this example, the output analog event gate signal 342 is input to a logic gate, for example AND'ed in AND logic gate 340, and combined with an enable (action condition) signal provided by a FSM state vector, such as FSM state vector 210 in FIG. 2. Although this example shows a use of a simple AND gate, it is also envisaged in other examples that a gate that waits for the signal to be '0' may be used before passing the signal through. The action condition signal defines in what state a specific analog event will trigger an action. The output action trigger signal 344 ('act_trig') from the AND logic gate 340 is used as an action flip-flop trigger, which in this example is a D-type flip flop 360 that indicates that a specific analog event has happened. Thus, the AND logic gate 340 is arranged to receive the output analog event gate signal 342 and the sequential logic circuit analog event enable signal and output an action trigger signal 344 to the register (D-type flip flop 360).The D-type flip flop 360 is reset 362 by a next phase action flop(s) from one of the other sequential logic circuits. The output of the action flip-flop (D-type flip flop 360) is gated in AND logic gate 370 with the action of the previous phase 372, in order to guarantee mutual exclusivity of the action, i.e. only one action is active at a time. In this manner, only if the action before is '0', the new action is set to '1'. The analog output signal 380 is then output from the example sequential logic circuit 300.

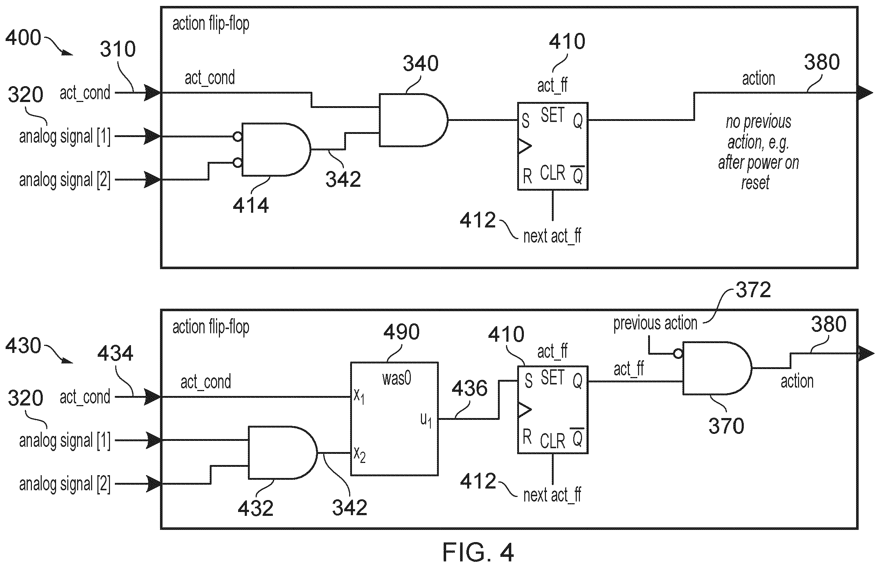

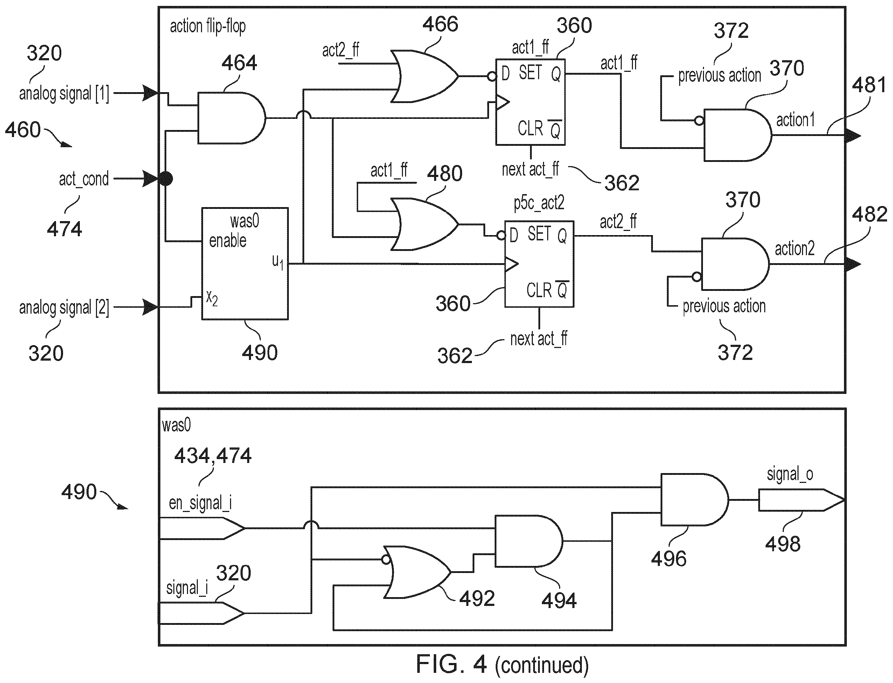

Referring now to FIG. 4, a number of example embodiments of sequential logic circuits are illustrated, according to some examples. A first example sequential logic circuit 400 triggers an action when a plurality of the analog input signals become logic '0'. It includes the analog input signals (1 .. n) 320 being inverted and AND'ed in AND logic gate 414. Thus, the analog event gate output 342 is AND'ed in AND logic gate 340 with an (action condition) enable signal provided by a FSM state vector, such as FSM state vector 210 in FIG. 2 to a first input 310. Unlike the example of FIG. 3, the output action trigger signal 344 from the AND logic gate 340 is input to the S input of a latch in a form of a S-R latch 410, which in this example indicates that a specific analog event has happened. The S-R latch 410 is reset 412 by a next phase action flop(s) from one of the other sequential logic circuits. Again, unlike the example of FIG. 3, the output of the action flip-flop (S-R latch 410) is not gated and provided direct as the output 380 as there is no need to guarantee mutual exclusivity of the action as there is no previous action, e.g., after a 'power-on' reset in this example. The analog output signal 380 is then output from the first example sequential logic circuit, i.e., S-R latch 410.

A second example sequential logic circuit 430 triggers an action when a plurality of the analog input signals become logic '1'. The analog event condition needs to transition from logic '0' to logic '1' in order to pass the analog event gate. The example circuit includes the analog input signals (1 .. n) 320 being AND'ed in AND logic gate 432. In this example, the analog event gate output 342 is input to a logic circuit 490, which also receives an enable (action condition) signal 434 provided by a FSM state vector, such as FSM state vector 210 in FIG. 2. The output 436 from the logic circuit 490 is input to the S input of a latch in a form of a S-R latch 410, which in this example indicates that a specific analog event has happened. The S-R latch 410 is reset 412 by a next phase action flop(s) from one of the other sequential logic circuits. Again, as in the example of FIG. 3, the output of the action flip-flop (S-R latch 410) is gated in AND logic gate 370 with the action of the previous phase 372, in order to guarantee mutual exclusivity of the action, i.e. only one action is active at a time. In this manner, only if the action before is '0', the new action is set to '1'. The analog output signal 380 is then output from the second example sequential logic circuit 430.

A third example sequential logic circuit 460 triggers different and mutually exclusive actions, depending on which of the analog input signals transitions to logic '1' first. It includes two analog input signals 320, with a first analog input signal being AND'ed in AND logic gate 464 with an enable (action condition) signal 474 provided by a FSM state vector, such as FSM state vector 210 in FIG. 2. A second analog input signal is input into a logic circuit 490, again with an enable (action condition) signal 474 provided by a FSM state vector, such as FSM state vector 210 in FIG. 2. In this example, the respective outputs from the logic circuit 490 and the AND logic gate 464 are used as a trigger for respective registers, for example D-type flip flops 360. The D inputs to the D-type flip flops 360 are inverted and provided by respective logic 'OR' gates 466, 480, where each receives a respective action flip flop signal and the output of one of the logic circuit 490 and the AND logic gate 464. The respective outputs of the action flip-flop (D-type flip flops 360) are each gated in AND logic gate 370 with the action of the previous phase 372, in order to guarantee mutual exclusivity of the action, i.e. only one action is active at a time. In this manner, only if the action before is '0', the new action is set to '1'. Respective analog output signals 481, 482 are then output from the third example sequential logic circuit 460. Although in the illustrated example outputs from the logic circuit 490 and the AND logic gate 464 are used as a trigger for respective registers, for example D-type flip flops 360, it is envisaged that in other applications that other flip flops or latches may be used as registers, as would be understood by skilled artisans.

The logic circuit 490 in the second example sequential logic circuit 430 and third example sequential logic circuit 460 is a gating circuit that only opens (passes through the input signal_i to signal_o), if the input signal, i.e., signal_i, was logic '0'. This is latched in the inner feedback loop. It includes a first input arranged to receive an enable signal 434, 474 and a second input arranged to receive the analog input signal 320. The analog input signal 320 is inverted and input to a first 'OR' logic gate 492 with a feedback signal. The first 'OR' logic gate 492 output is AND'ed with the enable signal 434, 474 in AND logic gate 494. The output of the AND logic gate 494 provides the feedback signal to the first 'OR' logic gate 492. This feedback latches if the input signal_i is logic '0'. The output of the AND logic gate 494 is also AND'ed in AND logic gate 496 with the analog input signal 320, to provide the logic circuit 490 output 498.

Referring now to FIG. 5, a block diagram of a digitally controlled analog RF impedance tuning circuit of an RFID device 500, adapted in accordance with some examples, is illustrated. In this example, the RFID device 500 is a wireless radio frequency identifier (RFID) device, and as such it contains an antenna 502 for receiving and for transmitting, where the antenna 502 is coupled to a resonance capacitor 510 that forms a resonance circuit together with the antenna. In parallel with the resonance capacitor 510 is a tunable RF impedance circuit comprising or a tunable bank of capacitors 520. The respective capacitances in the tunable bank of capacitors 520 are individually controlled, e.g., included within the capacitance or bypassed by a self-adjust circuit 530. The self-adjust circuit 530 includes a charge pump 532, a power level detector 534 and a digital self-adjust control circuit 536. In addition to, and in parallel with, the self-adjust circuit 530, a high frequency RFID main system 540 is employed. The high frequency RFID main system 540 includes a rectifier 542, a limiter 544, a modulator 546 arranged to modulate RFID signals for transmission, a demodulator 548 arranged to demodulate received RFID signals, a digital controller 550 and a non-volatile memory (NVM) 552. In accordance with examples described herein, the digital self-adjust controller 536 is connected to and applies analog control signals to adjust capacitances in the tunable bank of capacitors 520.

In some examples, the digital self-adjust control circuit 536 may be a finite state machine (FSM) that controls at least three phases of a decision on whether to adjust, say, a tuneable input impedance circuit in response to a detected received power level of an RFID signal and at least one captured respective analog event. In this example, the at least three phases include: (a) resetting sample capacitors in the tuneable input impedance circuit, (b) sampling/detecting the received power level (e.g., current input envelope voltage) of the RFID signal; (c) attempting a next tuning capacitor setting and deciding on whether there is an improvement in a supply voltage employed by the RFID device.

In some examples, the digital self-adjust control circuit 536 may employ a five-cap-step self-adjust algorithm, for example in accordance with the mapping table 4. In one example, the five-step self-adjust process may be applied to a digitally controlled analog RF impedance tuning circuit 505 that comprises four equal tuning capacitors in the capacitance bank 520. In this example, tuning may be performed in two rounds (with two steps in each direction). In this example, the five-step step self-adjust algorithm may attempt to adjust an input capacitance and check whether the adjustment improves, say, the supply voltage or not for, say, an RFID device. If yes, the change (adjustment) is kept, otherwise the change is discarded.

In a first step (step '0') two capacitors are enabled at startup, with say a set direction: = -1 (remove a capacitor) and set a tuning round = 1. In a second step (step '1') a change is made by adding or removing a capacitor in the bank of capacitors 520 (+/-1 capacitor) depending on direction. In a first part of a third step (step '2') if a chip input voltage increases, a decision is made to keep the change. If the tuning round == 2 then exit (assuming the tuning operation is finished); else: set tuning round = 2. In a second part of the third step (step '2'), else undo the change (following a timeout). If direction == -1 change the tuning direction to +1 (add a capacitor), else exit. If the tuning round == 2, exit; continue at the second step (step '1'). In this manner, the sequential logic circuit can trigger two different actions in response to one of: an observed supply improvement or a timeout elapsed.

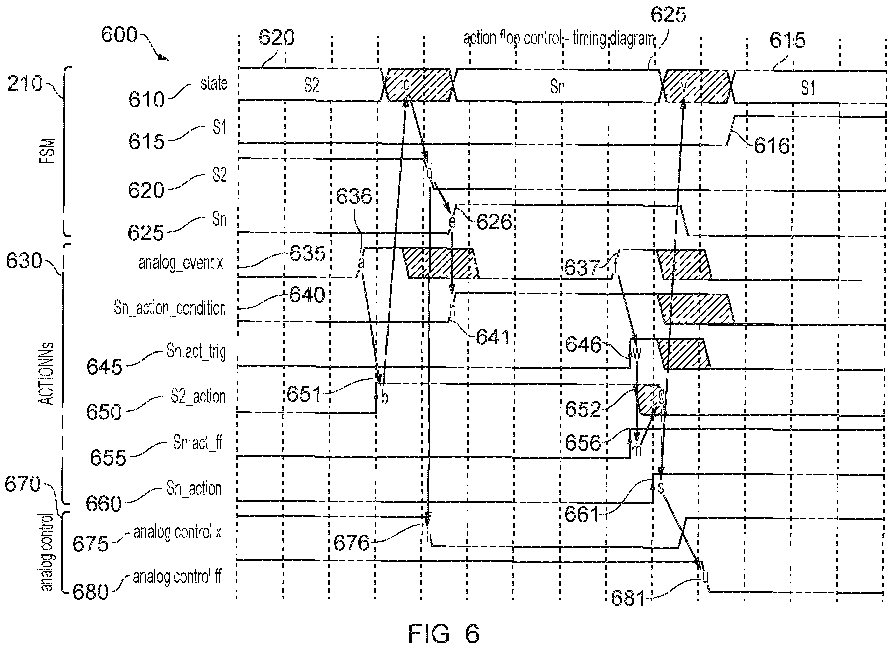

Referring now to FIG. 6, one example of an asynchronous timing control diagram 600 is illustrated, according to some examples. The signal timing is shown with respect to three circuits or functional operations: the timing of signals from FSM state vector circuit 210, actions 630 performed in two (actually: S2_action and Sn_action) of the sequential logic circuits (for example a sequential logic circuits 300 in FIG. 3 or FIG. 4) and analog control signals 670. The example asynchronous timing control diagram 600 illustrates two state transitions in 610 with the timing of respective signals from FSM state vector circuit 210: a first state transition from state 2 ('S2') 620 to another state ('Sn') 625 and a second state transition from state ('Sn') 625 to state 1 ('S1') 615.

In the actions timing signals 630, an analog event 'x' 635 illustrates an occurrence of an event, with a first analog event (timing transition) shown at 636. The first analog event 636 occurs during the state 2 ('S2') 620 and sets an action S2_action 650 with a signal transition from 'low' to 'high' at 651. This, in turn, causes a FSM state change in 610, which results in the state 2 ('S2') 620 signal going 'low' (S2 = 0) and analog control 'x' signal 675 also transitions 'low' at 676. These transitions occur prior to causing the new state, i.e., state ('Sn') 625 to transition 'high' (Sn = 1) at 626. This, in turn causes the 'Sn_action_condition=1' in 640, indicating that Sn_action is enabled at 641. In this situation, the FSM state vector circuit 210 drives the Sn sequential logic circuit via the Sn signal and analog controls are updated according to the FSM state. In this generic view, the primary purpose of the actions is to trigger the transition to the next state and to change some generic analog control signals.

Subsequently, as illustrated in the actions timing signals 630, a second analog event 'x' occurs, with the second analog event (timing transition) shown at 637. The second analog event 637 occurs during the state n ('Sn') 625 and causes/sets an action Sn_action trigger 645 with a signal transition from 'low' to 'high' (Sn.act_trig = '1') at 646. This causes the Sn:act_ff signal 655 transition 'high' (Sn.act_ff='1') at 656, which resets the action of the previous phase S2_action 650 at 652. Then, when S2_action==0, the Sn_action signal 660 transitions 'high' (Sn_action='1') at 661. This gating of Sn_action with S2_action==0 is needed in order to ensure actions are mutually exclusive, i.e., only one action is active at one time. Otherwise, actions would conflict. It is noted that S2_action is needed in order to guarantee mutual exclusivity. This, in turn, causes a FSM state change in 610, which results in the state n ('Sn') 625 signal going 'low' (Sn = 0) and analog control flops are updated, i.e., analog control 'ff' signal 680 also transitions 'low' at 681. These transitions occur prior to triggering the new FSM state, i.e., state ('S1') 615 to transition 'high' (S1 = 1) at 616. In this situation, the FSM state vector circuit 210 drives the S1 sequential logic circuit via the S1 signal. In this manner, again, S1 being gated with Sn==0, mutual exclusivity of the state signals (where only one state signal is 'high' at a time) is ensured. Otherwise, it is noted that the states would conflict.

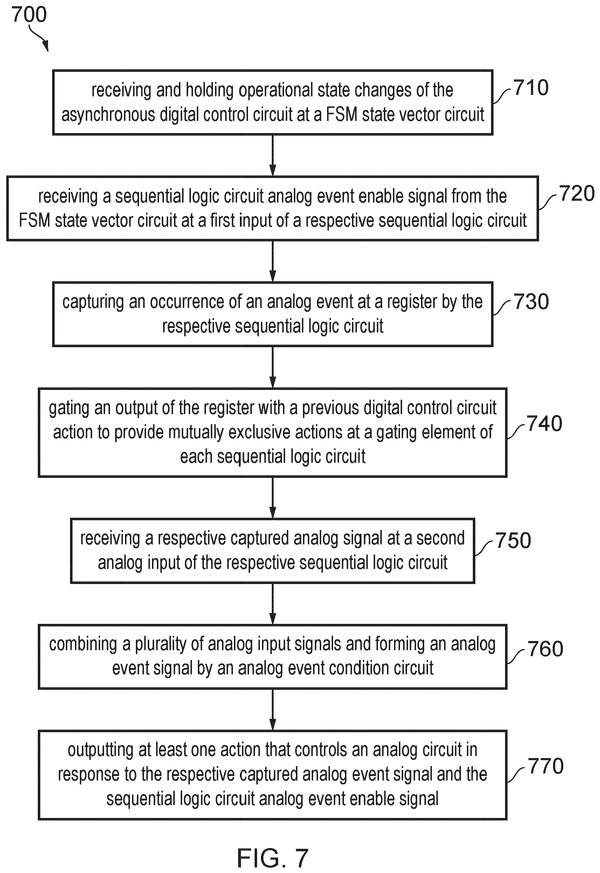

Referring now to FIG. 7, an overview example of a flowchart 700 illustrates a method for an asynchronous digital control circuit comprising a plurality of sequential logic circuits, such as sequential logic circuit 300 of FIG. 3, for example for adjusting a tunable input impedance of a RFID device, according to some examples. At 710 the flowchart includes receiving and holding operational state changes of the asynchronous digital control circuit at a finite state machine, FSM, state vector circuit, such as FSM, state vector circuit 210 of FIG. 2. At 720 the flowchart includes receiving a sequential logic circuit analog event enable signal from the FSM state vector circuit at a first input of a respective sequential logic circuit. At 730 the flowchart includes capturing an occurrence of an analog event at a register of the respective sequential logic circuit. At 740 the flowchart includes gating an output of the register with a previous digital control circuit action to provide mutually exclusive actions at a logic gate of each sequential logic circuit. At 750 the flowchart includes receiving a respective captured analog signal at a second analog input of the respective sequential logic circuit. At 760 the flowchart includes combining a plurality of analog input signals and forming an analog event signal by an analog event condition circuit. At 770 the flowchart includes outputting at least one action that controls an analog circuit in response to the respective captured analog event signal and the sequential logic circuit analog event enable signal.

It is envisaged that the concepts described herein may be used for various applications, and not just RFID devices, for example where improvements to synchronous digital timing of operations is desired (e.g., as would be found in low-power integrated circuits (ICs)).

It will be further appreciated that, for clarity purposes, the described embodiments with reference to different functional units and processors may be modified or re-configured with any suitable distribution of functionality between different functional units or processors being possible, without detracting from the concepts described herein. For example, functionality illustrated to be performed by separate processors or controllers may be performed by the same processor or controller. Hence, references to specific functional units are only to be seen as references to suitable means for providing the described functionality, rather than indicative of a strict logical or physical structure or organization.

In the foregoing specification, the examples have been described with reference to specific examples of potential implementations or applications. It will, however, be evident that various modifications and changes may be made therein without departing from the scope as set forth in the appended claims and that the claims are not limited to the specific examples described above.

The connections as discussed herein may be any type of connection suitable to transfer signals from or to the respective nodes or devices or circuits, for example via intermediate devices. Accordingly, unless implied or stated otherwise, the connections may for example be direct connections or indirect connections. The connections may be illustrated or described in reference to being a single connection, a plurality of connections, unidirectional connections, or bidirectional connections. However, different embodiments may vary the implementation of the connections. For example, separate unidirectional connections may be used rather than bidirectional connections and vice versa. Also, plurality of connections may be replaced with a single connection that transfers multiple signals serially or in a time multiplexed manner. Likewise, single connections carrying multiple signals may be separated out into various different connections carrying subsets of these signals. Therefore, many options exist for transferring signals. Those skilled in the art will recognize that the architectures depicted herein are merely exemplary, and that in fact many other architectures can be implemented which achieve the same functionality.

Any arrangement of components to achieve the same functionality is effectively 'associated' such that the desired functionality is achieved. Hence, any two components herein combined to achieve a particular functionality can be seen as 'associated with' each other such that the desired functionality is achieved, irrespective of architectures or intermediary components. Likewise, any two components so associated can also be viewed as being 'operably connected,' or 'operably coupled,' to each other to achieve the desired functionality.

Furthermore, those skilled in the art will recognize that boundaries between the above-described operations merely illustrative. The multiple operations may be combined into a single operation, a single operation may be distributed in additional operations and operations may be executed at least partially overlapping in time. Moreover, alternative embodiments may include multiple instances of a particular operation, and the order of operations may be altered in various other embodiments. Also, for example, in one embodiment, the illustrated examples may be implemented as circuitry located on a single integrated circuit or within a same device.

In some examples, the various components within the RFID may be realized in discrete or integrated component form, with an ultimate structure therefore being an application-specific or design selection. As the illustrated embodiments may, for the most part, be implemented using electronic components and circuits known to those skilled in the art, details will not be explained in any greater extent than that considered necessary as illustrated below, for the understanding and appreciation of the underlying concepts described herein and in order not to obfuscate or distract from the teachings described. A skilled artisan will appreciate that the level of integration of processor and memory circuits within the RFID may be, in some instances, implementation-dependent.

Also, for example, the examples, or portions thereof, may implemented as software or code representations of physical circuitry or of logical representations convertible into physical circuitry, such as in a hardware description language of any appropriate type. Also, the examples described are not limited to physical devices or units implemented in non-programmable hardware but can also be applied in programmable devices or units by operating in accordance with suitable program code, such as minicomputers, personal computers, notepads, personal digital assistants, automotive and other embedded systems, cell phones and various other wireless devices, commonly denoted in this application as 'devices'. However, other modifications, variations and alternatives are also possible. The specifications and drawings are, accordingly, to be regarded in an illustrative rather than in a restrictive sense.

In the claims, any reference signs placed between parentheses shall not be construed as limiting the claim. The word 'comprising' does not exclude the presence of other elements or steps then those listed in a claim. Furthermore, the terms 'a' or 'an,' as used herein, are defined as one or more than one. Also, the use of introductory phrases such as 'at least one' and 'one or more' in the claims should not be construed to imply that the introduction of another claim element by the indefinite articles 'a' or 'an' limits any particular claim containing such introduced claim element to inventions containing only one such element, even when the same claim includes the introductory phrases 'one or more' or 'at least one' and indefinite articles such as 'a' or 'an.' The same holds true for the use of definite articles. Unless stated otherwise, terms such as 'first' and 'second' are used to arbitrarily distinguish between the elements such terms describe. Thus, these terms are not necessarily intended to indicate temporal or other prioritization of such elements. The mere fact that certain measures are recited in mutually different claims does not indicate that a combination of these measures cannot be used to advantage.

## Claims

1. An asynchronous digital control circuit (200) comprising:
a finite state machine, FSM, state vector circuit (210) arranged to receive and hold operational state changes (215) of the asynchronous digital control circuit (200);
a plurality of sequential logic circuits (300) operably coupled to the FSM state vector circuit (210), wherein a number of the sequential logic circuits (300), comprise:
a first input (310) arranged to receive a sequential logic circuit analog event enable signal from the FSM state vector circuit (210);
a register (360) arranged to capture an occurrence of an analog event;
a logic gate (370) coupled to an output of the register (360) and arranged to gate the output of the register (360) with a previous digital control circuit action (372) to provide mutually exclusive actions;
a second analog input arranged to receive a respective captured analog signal (320);
an analog event condition circuit (350) having a plurality of combined logic circuits operably coupled to the second analog input and arranged to combine a plurality of analog input signals (320) to an analog event signal (342); and
an output arranged to output at least one action to control an analog circuit in response to the respective captured analog event signal and the sequential logic circuit analog event enable signal.

2. The asynchronous digital control circuit (200) of Claim 1 wherein the sequential logic circuit analog event enable signal is input to a dedicated, respective sequential logic circuit (300) that is activated by an event.

3. The asynchronous digital control circuit (200) of any preceding Claim wherein the analog event condition circuit (350) outputs an analog event gate signal (342).

4. The asynchronous digital control circuit (200) of Claim 3 further comprising a logic gate (340) arranged to receive the analog event gate signal (342) and the sequential logic circuit analog event enable signal and output an action trigger signal (344) to the register (360).

5. The asynchronous digital control circuit (200) of Claim 4 wherein the logic gate (340) is an 'AND' logic gate.

6. The asynchronous digital control circuit (200) of any preceding Claim wherein the analog event condition circuit (350) is arranged to combine a plurality of analog input signals (320) to form a logic '0' or logic '1'.

7. The asynchronous digital control circuit (200) of any preceding Claim wherein the register (360) arranged to capture an occurrence of an analog event is reset by a next phase sequential logic circuit.

8. The asynchronous digital control circuit (200) of any preceding Claim wherein the analog event condition circuit (350) comprises an AND logic gate (414) arranged to receive a respective inverted captured analog signal (320).

9. The asynchronous digital control circuit (200) of any preceding Claim wherein the output is arranged to output at least one action to control an analog circuit additionally in response to at least one state flag.

10. The asynchronous digital control circuit (200) of Claim 9 wherein the at least one state flag is set in response to an analog event and adjusts at least one input capacitance in a tuneable input impedance analog circuit that comprises a bank of capacitances.

11. The asynchronous digital control circuit (200) of any preceding Claim wherein the sequential logic circuit action signal is activated in response to one of: an observed supply improvement, a timeout elapsed.

12. A radio frequency identifier, RFID, device comprises an asynchronous digital control circuit (200) that comprises:
a finite state machine, FSM, state vector circuit (210) arranged to receive and hold operational state changes (215) of the asynchronous digital control circuit (200);
a plurality of sequential logic circuits (300) operably coupled to the FSM state vector circuit (210), wherein a number of the sequential logic circuits (300), comprise:
a first input (310) arranged to receive a sequential logic circuit analog event enable signal from the FSM state vector circuit (210);
a register (360) arranged to capture an occurrence of an analog event;
a logic gate (370) coupled to an output of the register (360) and arranged to gate the output of the register (360) with a previous digital control circuit action (372) to provide mutually exclusive actions;
a second analog input arranged to receive a respective captured analog signal (320);
an analog event condition circuit (350) having a plurality of combined logic circuits operably coupled to the second analog input and arranged to combine a plurality of analog input signals (320) to an analog event signal (342); and
an output arranged to output at least one action to control an analog circuit in response to the respective captured analog event signal and the sequential logic circuit analog event enable signal.

13. A method (700) for an asynchronous digital control circuit (200) comprising a plurality of sequential logic circuits (300), the method comprising:
receiving and holding (710) operational state changes (215) of the asynchronous digital control circuit (200) at a finite state machine, FSM, state vector circuit (210);
receiving (720) a sequential logic circuit analog event enable signal from the FSM state vector circuit (210) at a first input (310) of a respective sequential logic circuit (300);
capturing (730) an occurrence of an analog event at a register (360) by the respective sequential logic circuit (300);
gating (740) an output of the register (360) with a previous digital control circuit action (372) to provide mutually exclusive actions at a logic gate (370) of the respective sequential logic circuit (300);
receiving (750) a respective captured analog event signal (320) at a second analog input of the respective sequential logic circuit (300);
combining (760) a plurality of analog input signals (320) and forming an analog event signal by an analog event condition circuit (350); and
outputting (770) at least one action that controls an analog circuit in response to the respective captured analog event signal and the sequential logic circuit analog event enable signal.

14. The method (700) of Claim 13 further comprising inputting the sequential logic circuit analog event enable signal to a dedicated, respective sequential logic circuit (300), that is activated by an event.

15. The method (700) of Claim 13 or Claim 14 further comprising:
outputting an analog event gate signal (342) by the analog event condition circuit (350);
receiving the analog event gate signal (342) and the sequential logic circuit analog event enable signal by at a logic gate (340); and
outputting an action trigger signal (344) to the register (360) in response thereto.

## Amended claims

### Amended claims in accordance with Rule 137(2) EPC.

1. A radio frequency identifier, RFID, device (500) comprising:
an antenna (502) and a resonance circuit arranged to receive and transmit RFID signals;
a radio frequency impedance matching circuit coupled to the antenna (502) that comprises a tuneable bank of capacitors (520) coupled to the antenna (502);
a high frequency system (540) coupled to the antenna (502) and resonance circuit and arranged to modulate transmit RFID signals and demodulate received RFID signals; and
a digital self-adjust circuit (200, 536) coupled to the antenna (502), resonance circuit, radio frequency impedance matching circuit and high frequency system (540), wherein the digital self-adjust circuit (536) comprising:
a finite state machine, FSM, state vector circuit (210) arranged to receive and hold operational state changes (215) of the asynchronous digital control circuit (200);
a plurality of sequential logic circuits (300) operably coupled to the FSM state vector circuit (210), wherein a number of the sequential logic circuits (300), comprise:
a first input (310) arranged to receive a sequential logic circuit analog event enable signal from the FSM state vector circuit (210);
a register (360) arranged to capture occurrences of analog events;
a logic gate (370) coupled to an output of the register (360) and arranged to gate the output of the register (360) with a previous digital control circuit action (372) to provide mutually exclusive actions;
a second analog input arranged to receive a respective captured analog signal (320);
an analog event condition circuit (350) having a plurality of combined logic circuits operably coupled to the second analog input and arranged to combine a plurality of analog input signals (320) to an analog event signal (342) with one signal gating the next signal in an asynchronous, self-timed manner; and
an output arranged to adjust a tunable input impedance through adjustment of a capacitance of the tuneable bank of capacitors (520) of radio frequency impedance matching circuit in response to the respective captured analog event signals and the sequential logic circuit analog event enable signal.

2. The radio frequency identifier, RFID, device (500) of Claim 1 wherein the sequential logic circuit analog event enable signal is input to a dedicated, respective sequential logic circuit (300) that is activated by an event.

3. The radio frequency identifier, RFID, device (500) of any preceding Claim wherein the analog event condition circuit (350) outputs an analog event gate signal (342).

4. The radio frequency identifier, RFID, device (500) of Claim 3 further comprising a logic gate (340) arranged to receive the analog event gate signal (342) and the sequential logic circuit analog event enable signal and output an action trigger signal (344) to the register (360).

5. The radio frequency identifier, RFID, device (500) of Claim 4 wherein the logic gate (340) is an 'AND' logic gate.

6. The radio frequency identifier, RFID, device (500) of any preceding Claim wherein the analog event condition circuit (350) is arranged to combine a plurality of analog input signals (320) to form a logic '0' or logic '1'.

7. The radio frequency identifier, RFID, device (500) of any preceding Claim wherein the register (360) arranged to capture occurrences of analog events is reset by a next phase sequential logic circuit.

8. The radio frequency identifier, RFID, device (500) of any preceding Claim wherein the analog event condition circuit (350) comprises an AND logic gate (414) arranged to receive a respective inverted captured analog signal (320).

9. The radio frequency identifier, RFID, device (500) of any preceding Claim wherein the sequential logic circuit action signal is activated in response to one of: an observed supply improvement, a timeout elapsed.

10. A method (700) for a radio frequency identifier, RFID, device (500) comprising a radio frequency impedance matching circuit coupled to an antenna (502) that comprises a tuneable bank of capacitors (520) and an asynchronous digital control circuit (200) comprising a plurality of sequential logic circuits (300), the method comprising:
receiving and holding (710) operational state changes (215) of the asynchronous digital control circuit (200) at a finite state machine, FSM, state vector circuit (210);
receiving (720) a sequential logic circuit analog event enable signal from the FSM state vector circuit (210) at a first input (310) of a respective sequential logic circuit (300);
capturing (730) occurrence of analog events at a register (360) by the respective sequential logic circuit (300);
gating (740) an output of the register (360) with a previous digital control circuit action (372) to provide mutually exclusive actions at a logic gate (370) of the respective sequential logic circuit (300);
receiving (750) a respective captured analog event signal (320) at a second analog input of the respective sequential logic circuit (300);
combining (760) a plurality of analog input signals (320) and forming an analog event signal with one signal gating the next signal in an asynchronous, self-timed manner, by an analog event condition circuit (350); and
outputting (770) adjusting a capacitance of the tuneable bank of capacitors (520) of the radio frequency impedance matching circuit that adjusts a tunable input impedance in response to the respective captured analog event signals and the sequential logic circuit analog event enable signal.

11. The method (700) of Claim 10 further comprising inputting the sequential logic circuit analog event enable signal to a dedicated, respective sequential logic circuit (300), that is activated by an event.

12. The method (700) of Claim 10 or Claim 11 further comprising:
outputting an analog event gate signal (342) by the analog event condition circuit (350);
receiving the analog event gate signal (342) and the sequential logic circuit analog event enable signal by at a logic gate (340); and
outputting an action trigger signal (344) to the register (360) in response thereto.
